# EUROPEAN PATENT SPECIFICATION

(11) **EP 2 606 768 B1**
(45) Date of publication and mention of the grant of the patent: **30.09.2015**
(21) Application number: 11195669.4
(22) Date of filing: 23.12.2011
(51) Int. Cl.: A47B 88/12, H05K 7/14

(54) **Support device for bracket and rail of slide assembly**
Hilfsvorrichtung für eine Klammer und Schiene für eine Schiebeanordnung
Dispositif de support et rail d'ensemble coulissant

(43) Date of publication of application: 26.06.2013
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Huang, Chien-Li, Kaohsiung City (TW); Wang, Chun-Chiang, Kaohsiung City (TW)
(74) Representative: Viering, Jentschura & Partner Patent- und Rechtsanwälte

(56) References cited:
- EP-A1- 2 238 866
- US-A1- 2005 052 102
- US-A1- 2005 116 595
- US-A1- 2010 040 313
- US-B1- 6 578 939

## Description

### FIELD OF THE INVENTION

The present invention relates to a support device, and more particularly, to a more reliable support device for bracket and rails of a slide assembly.

### BACKGROUND OF THE INVENTION

Conventional support devices for bracket and rails of a slide assembly are disclosed in U.S. Patent No. 7,188,916 with the title of "Adjustable side rails and method of attaching same to mounting rails of cabinet racks" to Silverstro, U.S. Publication No. 2006/0152115 with the title of "Adjustable reinforcing bracket for telescoping slide rail assembly" to Dubon, and U.S. Publication No. 2008/0036347 with the title of "Rail device for extracting computer equipment" to Liang, all of which are provided for reference. Another slide assembly is also disclosed in the publication EP 2 238 866 A1.

Generally, the slide assembly comprises multiple rails, a front bracket and a rear bracket respectively located at the front end and the rear end of the slide assembly, wherein the rear bracket is usually movably connected to the slide assembly so as to adjust the length of the combination thereof. When the slide assembly with the brackets is used to a rack system, the front and rear brackets are connected to the rack, a server is connected to the slide assembly and a cable management arm is connected to the rear end of the slide assembly so as to manage the cables of the server. Because the cable management arm supports the cables so that their weight is significant and once the rear end of the slide assembly relative to the rear bracket cannot bear the weight of the cable management arm and the cables, the rails tends to be dragged downward or twisted relative to the rear bracket, and this affects the stability of support for the whole slide assembly.

A solution is needed to improve the shortcomings mentioned above.

The present invention intends to provide a reliable support device for bracket and rails of a slide assembly.

### SUMMARY OF THE INVENTION

The present invention relates to a support device for a slide assembly and comprises a bracket having a pair of support portions and a side portion which extends between the pair of the support portions. A path is defined by the side portion and the pair of the support portions. A rail is longitudinally connected to the path of the bracket and has a pair of outer walls and a side wall. The outer walls are located adjacent to the pair of the support portions of the bracket. The side wall extends between the pair of the outer walls and is located adjacent to the side portion of the bracket. Each of the pair of the support portions has a first support section extending from the side portion, a second support section bending from the first support section, and at least one first protrusion extending toward the path. The at least one first protrusion has a supporting face. Each of the pair of the outer walls has a first bent section extending from the side wall, a second bent section extending from the first bent section, and at least one protruding portion which has a contact face which is located corresponding to the supporting face. When the pair of the outer walls of the rail move relative to the pair of the support portions of the bracket, the contact face of the at least one protruding portion contacts the supporting face of the first protrusion.

Preferably, the second support section has a holding face which faces the path. The second support section is located adjacent to the second bent section. The first bent section has a first bent face which faces the path. The second bent section has a second bent face which faces the holding face of the second support section.

Preferably, the at least one first protruding portion is formed integrally with the holding face of the second support section by pressing and protrudes into the path.

Preferably, the at least one protruding portion is formed integrally with the first bent section of one of the outer walls by pressing and protrudes from the first bent face.

Preferably, a pair of extension sections extend from the two second bent sections and toward each other. The extension sections are substantially parallel to the side wall.

Preferably, the first protrusion is formed with a bent portion of the second support section and protrudes and reaches to the path. A second protrusion is located to the first support section and the second protrusion extends toward the at least one protruding portion of the rail and contacts the at least one protruding portion.

Preferably, the first protrusion is substantially perpendicular to and connected to the second protrusion.

The present invention further relates to a slide assembly and comprises a pair of outer walls and each of the outer walls has at least one protruding portion. Each of the outer walls has a first bent section and a second bent section extends from the first bent section. A side wall extends between the two outer walls and both of the side wall and the two outer walls have a longitudinal length. The at least one protruding portion has a contact face and the first bent section extends from the side wall. The first bent section has a first bent face and the second bent section has a second bent face. The at least one protruding portion protrudes beyond the first bent face and the contact face is located adjacent to the second bent face.

Preferably, the at least one protruding portion is formed integrally with the first bent section of one of the outer walls by pressing, and protrudes from the first bent face which is substantially parallel to the side wall.

Preferably, a pair of extension sections extend from the two second bent sections and toward each other. The extension sections are substantially parallel to the side wall.

The present invention will become more obvious from the following description when taken in connection with the accompanying drawings which show, for purposes of illustration only, a preferred embodiment in accordance with the present invention.

### BRIEF DESCRIPTION OF THE DRAWINGS

Fig. 1 is an exploded view to show the support device for a bracket and a rail of a slide assembly of the present invention;
Fig. 2 is a cross sectional view of the support device for a bracket and a rail of a slide assembly of the present invention;
Fig. 3 shows that the support device for a bracket and a rail of a slide assembly of the present invention has multiple first protrusions and protruding portions;
Fig. 4 shows that the support device for bracket and rails of a slide assembly of the present invention is applied by a load, and
Fig. 5 is a cross sectional view to show another embodiment of the support device for a bracket and a rail of a slide assembly of the present invention.

### DETAILED DESCRIPTION OF THE PREFERRED EMBODIMENT

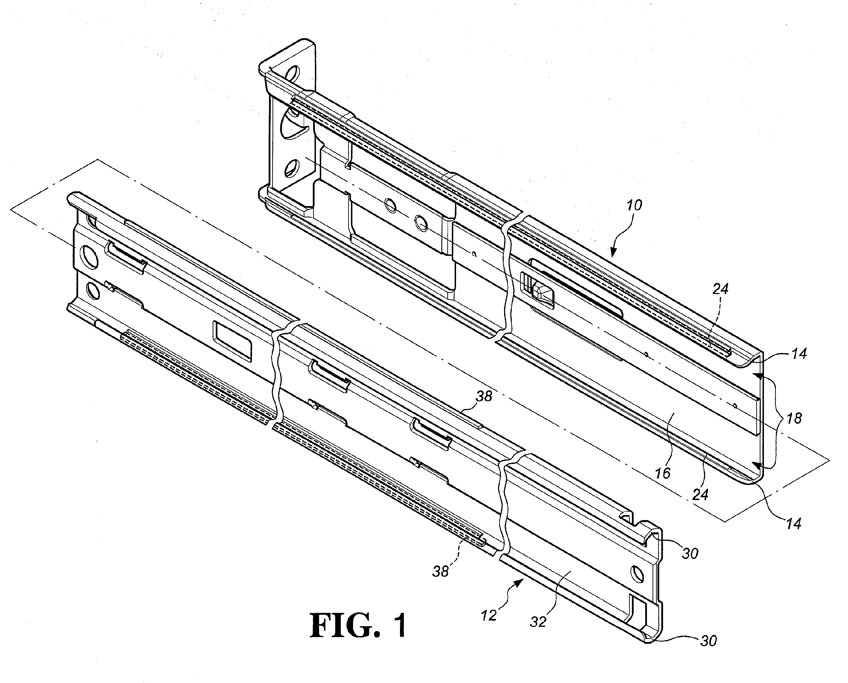

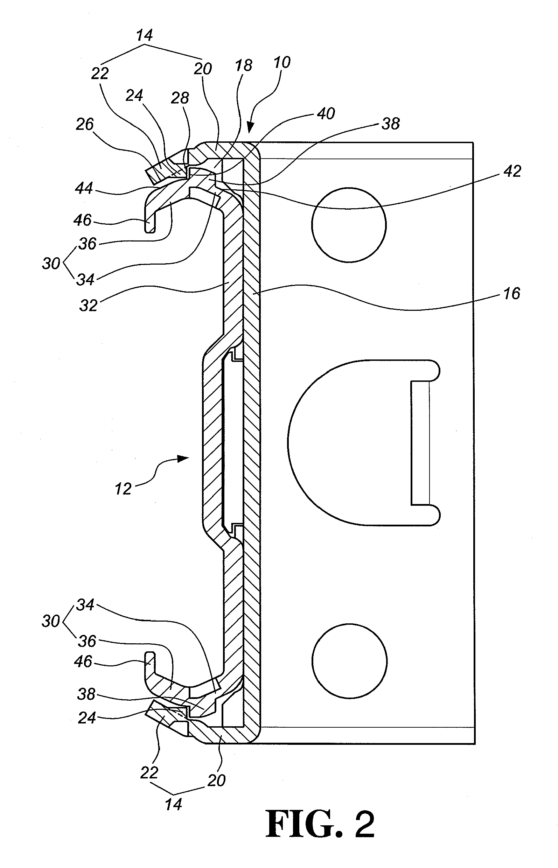

Referring to Figs. 1 and 2, the support device for a bracket 10 and a rail 12 of a slide assembly of the present invention, the bracket 10 has a pair of support portions 14 and a side portion 16, wherein the side portion 16 extends between the pair of the support portions 14. A path 18 is defined by the side portion 16 and the pair of the support portions 14. In this embodiment, each of the pair of the support portions 14 has a first support section 20 extending from the side portion 16, a second support section 22 extending from the first support section 20, and a first protrusion 24 extending toward the path 18. The second support section 22 has a holding face 26 which faces the path 18, and the first protrusion 24 has a supporting face 28. Preferably, the first protruding 24 is formed integrally with the holding face 26 of the second support section 22 by pressing and protrudes into the path 18.

The rail 12 is longitudinally connected to the path 18 of the bracket 10 and comprises a pair of outer walls 30 and a side wall 32. The pair of the outer walls 30 are located adjacent to the pair of the support portions 14 of the bracket 10. The side wall 32 extends between the pair of the outer walls 30. The side wall 32 is located adjacent to the side portion 16 of the bracket 10. In this embodiment, each of the pair of the outer walls 30 has a first bent section 34 extending from the side wall 32, a second bent section 36 extending from the first bent section 34, and a protruding portion 38 located on outside one of the outer walls 30. The protruding portion 38 has a contact face 40 which is located corresponding to the supporting face 28 of the first protrusion 24. The contact face 40 faces the supporting face 28. The second support section 22 is located adjacent to the second bent section 36. The first bent section 34 has a first bent face 42 which faces the path 18. The second bent section 36 has a second bent face 44 which faces the holding face 26 of the second support section 22. Preferably, the contact face 40 of the protruding portion 38 is located adjacent to the second bent face 44 and the contact face 40 is substantially parallel to the side wall 32.

In one preferable embodiment, the protruding portion 38 is formed integrally with the first bent section 34 of one of the outer walls 30 by pressing and protrudes from the first bent face 42.

In one preferable embodiment, the present invention further comprises a pair of extension sections 46 which extend from the two second bent sections 36 and toward each other. The pair of the extension sections 46 are substantially parallel to the side wall 32.

In one preferable embodiment, the second support section 22 is bent from the first support section 20 and is located adjacent to the second bent section 36 of the rail 12.

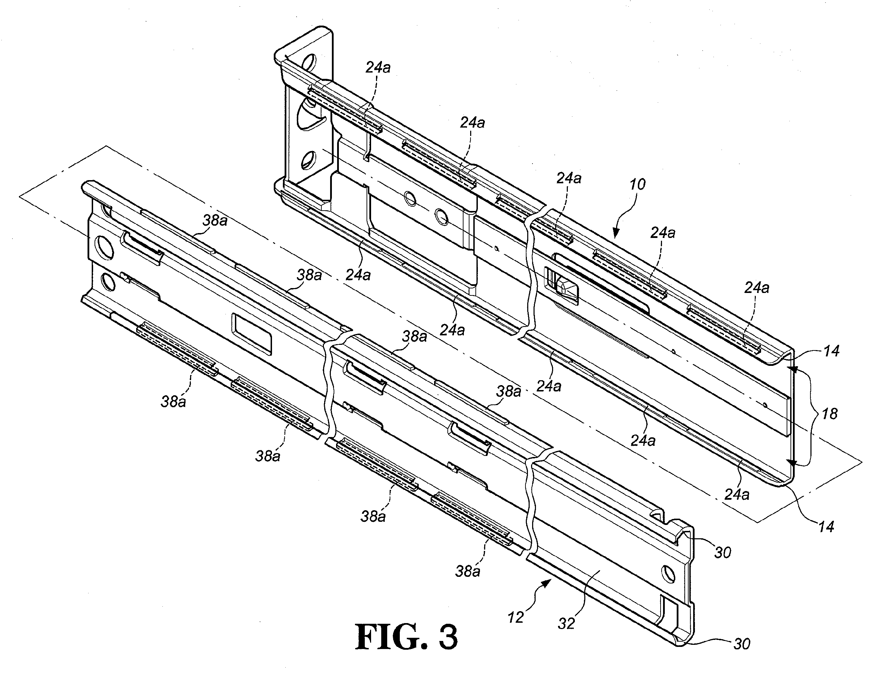

In one preferable embodiment, as shown in Fig. 3, the bracket 10 has a longitudinal length and each of the support portions 14 of the bracket 10 has multiple first protrusions 24a which face the path 18. The side wall 32 of the rail 12 and the pair of the outer walls 30 have a longitudinal length and each of the pair of the outer walls 30 of the rail 12 has multiple protruding portions 38a.

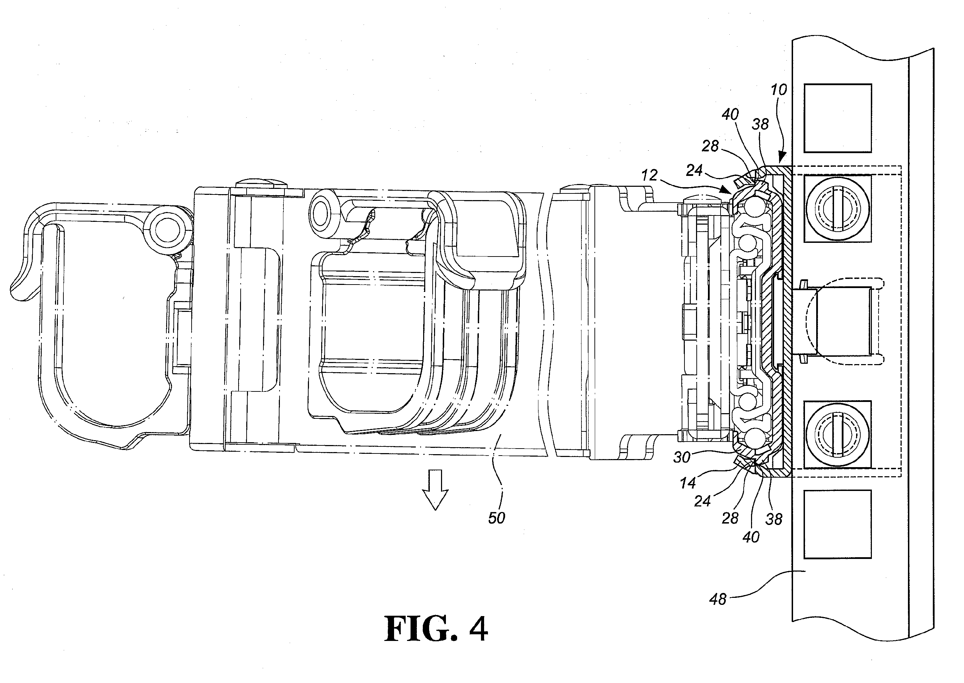

Fig. 4 shows that the bracket 10 is installed to a rack 48 and multiple rails 12 are provided so that a cable management arm 50 is connected thereto. According to the arrangement of the present invention, when the weight of the cable management arm 50 is applied to the rails 12 which are deformed or twisted relative to the bracket 10, the pair of the outer walls 30 of the rail 12 move relative to the pair of the support portions 14 of the bracket 10, and the contact face 40 of the protruding portion 38 contacts the supporting face 28 of the first protrusion 24 to ensure that the rail 12 does not drop from the bracket 10.

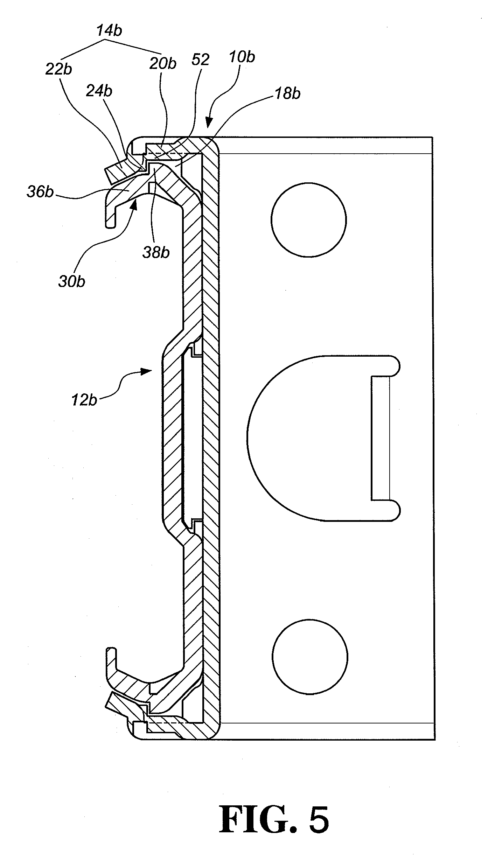

In another embodiment, as shown in Fig. 5, the first protrusion 24b is formed with a bent portion of the second support section 22b and protrudes into the path 18b. Each of the support portions 14b has at least one second protrusion 52 located to the first support section 20b and extending toward the protruding portion 38b of the rail 12b, and the second protrusion 52 may contact the protruding portion 38. Preferably, the first protrusion 24b is substantially perpendicular to and connected to the second protrusion 52. When the outer walls 30b of the rail 12b move relative to the support portions 14b of the bracket 10b, the second bent section 36b of the rail 12b contacts the second support section 22b of the bracket 10 to reinforce the support from the bracket 10b to the rail 12b.

While we have shown and described the embodiment in accordance with the present invention, it should be clear to those skilled in the art that further embodiments may be made without departing from the scope of the present invention.

## Claims

1. A support device for a slide assembly, comprising:
a bracket (10) having a pair of support portions (14) and a side portion (16), the side portion (16) extending between the pair of the support portions (14), a path (18) defined by the side portion (16) and the pair of the support portions (14), a rail (12) longitudinally connected to the path (18) of the bracket (10), the rail (12) having a pair of outer walls (30) and a side wall (32), the pair of the outer walls (30) located adjacent to the pair of the support portions (14) of the bracket (10), the side wall (32) extending between the pair of the outer walls (30), the side wall (32) located adjacent to the side portion (16) of the bracket (10), **characterized by**:
each of the pair of the support portions (14) having a first support section (20) extending from the side portion (16), a second support section (22) bending from the first support section (20), and at least one first protrusion (24) extending toward the path (18), the at least one first protrusion (24) having a supporting face (28), each of the pair of the outer walls (30) having a first bent section (34) extending from the side wall (32), a second bent section (36) extending from the first bent section (34) and at least one protruding portion (38), the at least one protruding portion (38) having a contact face (40) which is located corresponding to the supporting face (28), when the pair of the outer walls (30) of the rail (12) move relative to the pair of the support portions (14) of the bracket (10), the contact face (40) of the at least one protruding portion (38) contacts the supporting face (28) of the at least one first protrusion (24).

2. The device as claimed in claim 1, wherein the second support section (22) has a holding face (26) which faces the path (18), the second support section (22) is located adjacent to the second bent section (36), the first bent section (34) has a first bent face (42) which faces the path (18), the second bent section (36) has a second bent face (44) which faces the holding face (26) of the second support section (22).

3. The device as claimed in claim 2, wherein the at least one first protruding portion (24) is formed integrally with the holding face (26) of the second support section (22) by pressing and protrudes into the path (18).

4. The device as claimed in claim 2, wherein the at least one protruding portion (38) is formed integrally with the first bent section (34) of one of the outer walls (30) by pressing and protrudes from the first bent face (42).

5. The device as claimed in claim 2 further comprising a pair of extension sections (46) which extend from the two second bent sections (36) and toward each other, the extension sections (46) are substantially parallel to the side wall (32).

6. The device as claimed in claim 2, wherein the at least one first protrusion (24) is formed with a bent portion of the second support section (22) and protrudes and reaches to the path (18), a second protrusion (52) is located to the first support section (20), the second protrusion (52) extends toward the at least one protruding portion (38) of the rail (12) and contacts the at least one protruding portion (38).

7. The device as claimed in claim 6, wherein the at least one first protrusion (24) is substantially perpendicular to and connected to the second protrusion (52).

## Patentansprüche

1. Eine Stützvorrichtung für einen Tragarm und eine Schiene, umfassend:
einem Tragarm (10) mit einem Paar Stützflansche (14) und einem Seitenteil (16), wobei sich das Seitenteil (16) zwischen dem Paar Stützflansche (14) erstreckt; ein Weg (18) mit dem Seitenteil (16) und dem Paar Stützflansche (14) gebildet wird; eine Schiene (12) der Länge nach am Weg (18) des Tragarms (10) befestigt ist; die Schiene (12) mit einem Paar Außenwände (30) und mit einer Seitenwand (32) gebildet ist; das Paar Außenwände (30) anstoßend am Paar Stützflansche (14) des Tragarms (10) angeordnet ist; sich die Seitenwand (32) zwischen dem Paar Außenwände (30) erstreckt; die Seitenwand (32) anstoßend am Seitenteil (16) des Tragarms (10) angeordnet ist, **dadurch gekennzeichnet, dass**:
jedes Paar Stützflansche (14) mit einem ersten Stützteil (20) gebildet ist, das sich vom Seitenteil (16) erstreckt; ein zweites Stützteil (22) vom ersten Stützteil (20) gebogen ist und sich mindestens ein erster Vorsprung (24) zum Weg (18) erstreckt; der mindestens eine erste Vorsprung (24) eine Stützfläche (28) aufweist; jedes der Paare Außenwände (30) mit einem gebogenen Abschnitt (34) gebildet ist, der sich von der Seitenwand (32) erstreckt; sich ein zweiter gebogener Abschnitt (36) vom ersten gebogenen Abschnitt (34) und mindestens einer vorstehenden Kante (38) erstreckt; die mindestens eine vorstehende Kante (38) eine Berührungsfläche (40) aufweist, die entsprechend der Stützfläche (28) gebildet ist; beim Bewegen des Paars Außenwände (30) der Schiene (12) relativ zum Paar Stützflansche (14) des Tragarms (10) die Berührungsfläche (40) der mindestens einen vorstehenden Kante (38) mit der Stützfläche (28) des mindestens einen ersten Vorsprungs (24) in Berührung kommt.

2. Die Vorrichtung nach Anspruch 1, wobei das zweite Stützteil (22) eine Tragefläche (26) gegenüber dem Weg (18) aufweist; das zweite Stützteil (22) anstoßend am zweiten gebogenen Abschnitt (36) angeordnet ist; der erste gebogene Abschnitt (34) eine erste gebogene Fläche (42) gegenüber dem Weg Weg (18) aufweist; der zweite gebogene Abschnitt (36) eine zweite gebogene Fläche (44) gegenüber der Tragefläche (26) des zweiten Stützteils (22) angeordnet ist.

3. Die Vorrichtung nach Anspruch 2, wobei die mindestens eine erste vorstehende Kante (24) durch Andrücken einstückig mit der Tragefläche (26) des zweiten Stützteils (22) gebildet ist und in den Weg (18) vorsteht.

4. Die Vorrichtung nach Anspruch 2, wobei die mindestens eine vorstehende Kante (38) durch Andrücken einstückig mit dem ersten gebogenen Abschnitt (34) einer der Außenwände (30) gebildet ist und von der ersten gebogenen Fläche (42) vorsteht.

5. Die Vorrichtung nach Anspruch 2, weiter bestehend aus einem Paar vorstehender Enden (46), die sich von den beiden zweiten gebogenen Abschnitten Abschnitts (36) und zueinander erstrecken, wobei das vorstehende Ende (46) im Wesentlichen parallel zur Seitenwand (32) angeordnet ist.

6. Die Vorrichtung nach Anspruch 2, wobei der mindestens eine erste Vorsprung (24) mit einem gebogenen Teil des zweiten Stützteils (22) gebildet ist und in den Weg (18) vorsteht; ein zweiter Vorsprung (52) am ersten Stützteil (20) angeordnet ist; sich der zweite Vorsprung (52) zu der mindestens einen vorstehenden Kante (38) der Schiene (12) erstreckt und mit dieser mindestens einen vorstehenden Kante (38) in Berührung steht.

7. Die Vorrichtung nach Anspruch 6, wobei der mindestens eine erste Vorsprung (24) im Wesentlichen senkrecht zum zweiten Vorsprung (52) angeordnet und an diesem befestigt ist.

## Revendications

1. Un dispositif d'appui pour un ensemble coulissant, comprenant :
un support (10) ayant une paire de parties d'appui (14) et une partie latérale (16), la partie latérale (16) se prolongeant entre la paire de parties d'appui (14), une trajectoire (18) définie par la partie latérale (16) et la paire de parties d'appui (14), un rail (12) relié de manière longitudinale à la trajectoire (18) du support (10), le rail (12) ayant une paire de parois externes (30) et une paroi interne (32), la paire de parois externes (30) situées de manière adjacente par rapport à la paire de parties d'appui (14) du support (10), la paroi interne (32) se prolongeant entre la paire de parois externes (30), la paroi interne (32) située de manière adjacente par rapport à la partie latérale (16) du support (10), **caractérisé en ce que** :
chaque partie d'appui (14) ayant une première section d'appui (20) se prolongeant à partir de la partie latérale (16), une deuxième section d'appui (22) pliée à partir de la première section d'appui (20), et au moins une première saillie (24) se prolongeant vers la trajectoire (18), la ou les premières saillies (24) ayant une surface d'appui (28), chaque paroi externe (30) ayant une première section pliée (34) se prolongeant à partir de la paroi interne (32), une deuxième section pliée (36) se prolongeant à partir de la première section pliée (34) et au moins une partie saillante (38), la ou les parties saillantes (38) ayant une surface de contact (40) qui est située en correspondance avec la surface d'appui (28), quand la paire de parois externes (30) du rail (12) se déplacent par rapport à la paire de parties d'appui (14) du support (10), la surface de contact (40) de la ou des parties saillantes (38) entre en contact avec la surface d'appui (28) de la ou des premières saillies (24).

2. Le dispositif selon la revendication 1, dans lequel la deuxième section d'appui (22) a une surface de retenue (26) qui fait face à la trajectoire (18), la deuxième section d'appui (22) est située de manière adjacente par rapport à la deuxième section pliée (36), la première section pliée (34) a une première surface pliée (42) qui fait face à la trajectoire (18), la deuxième section pliée (36) a une deuxième surface pliée (44) qui fait face à la surface de retenue (26) de la deuxième section d'appui (22).

3. Le dispositif selon la revendication 2, dans lequel la ou les premières parties saillantes (24) sont formées intégralement avec la surface de retenue (26) de la deuxième section d'appui (22) par pression et font saillie dans la trajectoire (18).

4. Le dispositif selon la revendication 2, dans lequel la ou les parties saillantes (38) sont formées intégralement avec la première section pliée (34) de l'une des parois externes (30) par pression et font saillie à partir de la première surface pliée (42).

5. Le dispositif selon la revendication 2 comprenant en outre une paire de prolongements (46) qui s'étendent à partir des deux deuxièmes sections pliées (36) et l'une vers l'autre, les prolongements (46) sont substantiellement parallèles à la paroi interne (32).

6. Le dispositif selon la revendication 2, dans lequel la ou les premières saillies (24) sont formées avec une partie pliée de la deuxième section d'appui (22) et font saillie et atteignent la trajectoire (18), une deuxième saillie (52) est située près de la première section d'appui (20), la deuxième saillie (52) se prolonge vers la ou les parties saillantes (38) du rail (12) et entre en contact avec la ou les parties saillantes (38).

7. Le dispositif selon la revendication 6, dans lequel la ou les premières saillies (24) sont substantiellement perpendiculaires à la deuxième saillie et y sont reliées (52).
